# EUROPEAN PATENT APPLICATION

(11) **EP 1 962 333 A1**
(43) Date of publication of application: **27.08.2008**
(21) Application number: 06833633.8
(22) Date of filing: 29.11.2006
(51) Int. Cl.: H01L 21/301

(54) **SEMICONDUCTOR DEVICE MANUFACTURING METHOD**

(30) Priority: 16.12.2005 JP 2005363696
(71) Applicant: Olympus Corporation, Tokyo 151-0072 (JP)
(72) Inventor: KOJIMA, Kazuaki, Tokyo 151-0072 (JP)
(74) Representative: Winter, Brandl, Fürniss, Hübner Röss, Kaiser, Polte Partnerschaft Patent- und Rechtsanwaltskanzlei
(86) International application number: PCT/JP2006/323829
(87) International publication number: WO 2007/069456

(57) **Abstract**

An object of the present invention is to provide a method for fabricating a semiconductor device to fabricate a semiconductor device contributing to the improvement of yield and having a high reliability by reducing or avoiding the generation of chippings in a dicing step for a hetero₋junction substrate. To achieve such an object, the present invention relates to a method for fabricating a semiconductor device composed of a hetero-junction substrate formed of a semiconductor substrate, and a heterogeneous substrate made of a material other than semiconductor bonded to a surface of the semiconductor substrate. A dicing step of cutting the hetero-junction substrate into semiconductor chips comprises a first dicing step of forming grooves having a depth of at least the thickness of the semiconductor substrate on the surface of the semiconductor substrate; and a second dicing step of cutting the entire hetero₋junction substrate along the grooves to divide the hetero-junction substrate into a plurality of semiconductor chips.

## Description

### Technical Field

The present invention relates to a method for fabricating a semiconductor device, and more specifically to a method for fabricating a semiconductor device including a dicing step for a semiconductor device having a hetero-junction substrate.

### Background Art

In addition to electronic cameras such as electronic still cameras and digital video cameras, demand for a semiconductor device such as a solid-state image pickup apparatus has been increased in recent years in the field of various electronic apparatuses, such as small cameras used as an additional function mounted in small electronic apparatuses, such as electronic organizers and mobile phones.

In these various electronic apparatuses, technology such as chip size packaging (CSP) has rapidly reduced the size of the semiconductor devices. Particularly in solid-state image pickup apparatuses, various fabricating methods for singulating semiconductor chips, for example, a wafer level chip size packaging (WL-CSP), have conventionally been proposed, such as in Japanese Patent Application Laid-Open Publication No. 2003-116066, in which a hetero-junction substrate formed by bonding a semiconductor substrate, on which elements of image pickup devices or the like are formed, to a transparent substrate is processed and diced to finally configure a part of a semiconductor device.

The method for fabricating a solid-state image pickup apparatus disclosed in the above-described Japanese Patent Application Laid-Open Publication No. 2003-116066 is a substrate dicing method of a solid-state image pickup apparatus formed with a bonded transparent substrate, in which a V-shaped dicing blade is used to perform half-dicing for forming a V-shaped groove, and then full-dicing is performed using a dicing blade having a width narrower than the width of the V-shaped groove so as to form chamfer portions on the outer peripheral portion of a surface of a singulated semiconductor substrate (for example, the upper surface side of a transparent substrate).

In this way, chamfer portions can be formed on the outer peripheral portion of the upper surface of a transparent substrate in the dicing process for singulation.

Specifically, in the step of assembling a solid-state image pickup apparatus having chamfer portions in a corresponding electronic device, for example, there is possibility of damages to the part such as cracks on the transparent substrate occurring when the transparent substrate hits another component, such as a lens block. Therefore, by forming the above-described chamfer portions on the peripheral portion of the upper surface of the transparent substrate, damages to the part such as the cracks on the transparent substrate can be avoided.

However, according to the means disclosed in the above-described Japanese Patent Application Laid-Open Publication No. 2003-116066, although damages to the part due to chippings or the like occurring on the side of a transparent substrate as described above can be avoided, the avoidance of chippings occurring on the side of a semiconductor substrate on which an image pickup device is formed is not considered. Therefore, chippings may possibly occur in the semiconductor substrate with this means.

Specifically, in a heterogeneous material of a transparent substrate such as a glass plate and a semiconductor substrate such as a silicon substrate, the chipping quantity, and the optimum width and material of the dicing blade significantly vary depending to the material used.

Therefore, if a semiconductor substrate is cut using a dicing blade for cutting transparent substrates, larger chippings occur to reach the device region.

If a transparent substrate is cut using a dicing blade for cutting semiconductor substrates, excessive time may be required, and in some cases, a trouble such as the cracks on the dicing blade may occur.

In light of the above-described circumstance, it is an object of the present invention is to provide a semiconductor device fabricating method for fabricating a semiconductor device contributing to the improvement of yield and having a high reliability by reducing or avoiding the generation of chippings in a dicing step for a hetero-junction substrate.

### Disclosure of Invention

### Means for Solving the Problem

To achieve the above-described object, a method for fabricating a semiconductor device according to the present invention is a method for fabricating a semiconductor device composed including a hetero-junction substrate formed of a semiconductor substrate and a heterogeneous substrate made of a material other than semiconductor bonded to a surface of the semiconductor substrate, wherein a dicing step of cutting the hetero-junction substrate into semiconductor chips includes a first dicing step of forming grooves having a depth of at least half the thickness of the semiconductor substrate on the surface of the semiconductor substrate; and a second dicing step of cutting the entire hetero-junction substrate along the grooves so as to divide the hetero-junction substrate into a plurality of semiconductor chips.

### Brief Description of the Drawings

Fig. 1 is a side view showing the schematic configuration of a final form of a semiconductor device fabricated by a fabricating method to which the present invention is applied;
Fig. 2 is a sectional view illustrating a fabricating method of a semiconductor device according to a first embodiment of the present invention, and showing a first dicing step;
Fig. 3 is a sectional view illustrating the fabricating method of the semiconductor device according to the first embodiment of the present invention, and showing a second dicing step;
Fig. 4 is a sectional view illustrating the fabricating method of the semiconductor device according to the first embodiment of the present invention, and showing a part of a semiconductor chip (only a vicinity of a diced region) in a semiconductor device singulated in two-stage dicing steps;
Fig. 5 is a sectional view illustrating a fabricating method of a semiconductor device according to a second embodiment of the present invention, showing a first dicing (etching) step, and showing a state wherein an etching mask is disposed on the back side of a semiconductor substrate;
Fig. 6 is a sectional view illustrating the fabricating method of the semiconductor device according to the second embodiment of the present invention, and showing a state after the completion of the first dicing (etching) step;
Fig. 7 is a sectional view illustrating the fabricating method of the semiconductor device according to the second embodiment of the present invention, and showing a second dicing step;
Fig. 8 is a sectional view illustrating the fabricating method of the semiconductor device according to the second embodiment of the present invention, and showing a part of a semiconductor chip (only a vicinity of a diced region) in a semiconductor device singulated in two-stage dicing steps;
Fig. 9 is a sectional view illustrating a fabricating method of a semiconductor device according to a third embodiment of the present invention, showing a first dicing (etching) step, and showing a state wherein an etching mask is disposed on the back side of a semiconductor substrate;
Fig. 10 is a sectional view illustrating the fabricating method of the semiconductor device according to the third embodiment of the present invention, and showing a state after the completion of the first dicing (etching) step;
Fig. 11 is a sectional view illustrating the fabricating method of the semiconductor device according to the third embodiment of the present invention, and showing a second dicing step; and
Fig. 12 is a sectional view illustrating the fabricating method of the semiconductor device according to the third embodiment of the present invention, and showing a part of a semiconductor chip (only a vicinity of a diced region) in a semiconductor device singulated in two-stage dicing steps.

### Best Mode for Carrying Out the Invention

The present invention will be described hereunder with reference to embodiments shown in the drawings.

First, before an embodiment of the present invention is described, a schematic configuration of a semiconductor device fabricated by applying the present invention will be described.

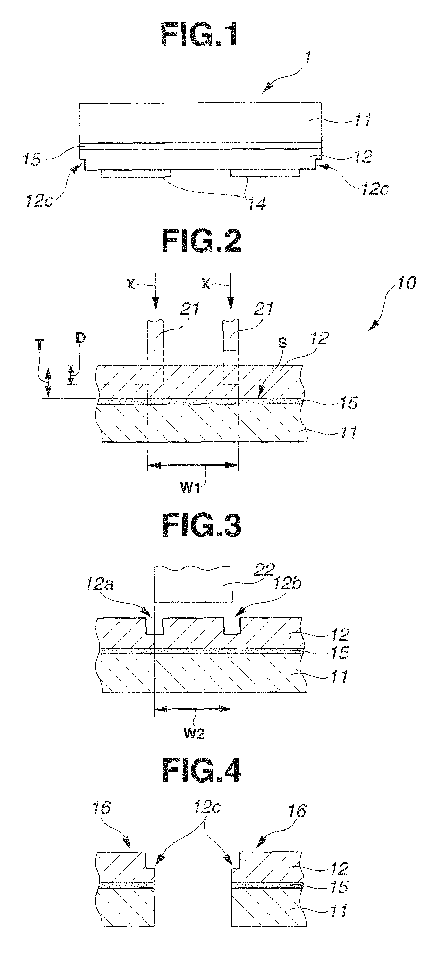

Fig. 1 is a side view showing the schematic configuration of a final form of a semiconductor device fabricated by a fabricating method to which the present invention is applied.

As shown in Fig. 1, the semiconductor device 1 fabricated by applying the present invention is composed of a hetero-junction substrate formed by bonding a transparent substrate 11, such as a glass substrate, to a semiconductor substrate 12, such as a silicon substrate, using an adhesive 15 or the like.

On the back face of the semiconductor substrate 12 of the hetero- junction substrate, an externally connecting terminal 14 for drawing signals from a circuit formed on the surface of the semiconductor substrate 12 to the outside is formed. The externally connecting terminal 14 is electrically connected to a pad electrode (not shown) formed on the surface of the semiconductor substrate 12 via a substrate penetrating electrode (not shown).

A notch 12c is formed on the outer peripheral portion of the outer surface on the back face side of the semiconductor substrate 12.

Next, respective embodiments for fabricating methods when a semiconductor device of such a form is fabricated will be described hereunder.

In respective embodiments described hereunder, the case where a solid-state image pickup apparatus is fabricated as a semiconductor device will be described as an example.

Figs. 2 to 4 are diagrams for illustrating a method for fabricating a semiconductor device according to the first embodiment of the present invention. Of these diagrams, Fig. 2 is a sectional view showing a first dicing step. Fig. 3 is a sectional view showing a second dicing step. Fig. 4 is a sectional view showing a part of a semiconductor chip (only a vicinity of a diced region) in a semiconductor device singulated in two-stage dicing steps.

In the method for fabricating a semiconductor device according to the present embodiment, the dicing process is divided into two stages. In the present embodiment, both a first dicing step and a second dicing step in two-stage dicing steps are carried out by a mechanical processing.

In the process in the method for fabricating a semiconductor device, prior to the dicing process, first, a semiconductor wafer composed of a semiconductor substrate 12 to be diced is formed. The semiconductor wafer is a semiconductor wafer of a form wherein a plurality of semiconductor substrate portions of a semiconductor device fabricated using the fabricating method of the present embodiment, specifically, a solid-state image pickup apparatus. On the surface of the semiconductor wafer, a hetero-junction substrate of the form wherein transparent substrate is joined with an adhesive or the like is formed.

The dicing process in the present embodiment is a process for dicing the hetero-junction substrate, and is a specific form in dicing processes for singulation into a plurality of semiconductor chips.

Specifically, in the first dicing step in the dicing process in the fabricating method according to the present embodiment, as shown in Fig. 2, dicing is performed at two locations of the both end portions of a predetermined dicing region W1 of a semiconductor substrate 12 (refer to Fig. 2), such as a silicon substrate, in the hetero-junction substrate 10 toward the arrow X direction in Fig. 2 using a first dicing blade 21 for semiconductor substrates. Thereby, as shown in Fig. 3, two grooves 12a and 12b are formed on the outer surface (back face side) of the semiconductor substrate 12.

In this case, dicing by the first dicing blade 21 is performed from the outer surface in the back face of the semiconductor substrate 12 to at least the depth of about half the thickness T of the semiconductor substrate 12 (refer to Fig. 2) or more (for example, the depth D shown in Fig. 2). Thereby, on the outer surface in the back face of the semiconductor substrate 12, two grooves 12a and 12b of a depth of D are formed as shown in Fig. 2.

As described above, the depth D of the two grooves 12a and 12b formed in the first dicing step may be deeper than about a half the thickness T of the semiconductor substrate 12.

Therefore, the first dicing step is not limited to the above-described example shown in Fig. 2, but for example, dicing may be performed to cover the thickness T of the semiconductor substrate 12 from outer surface in the back face of the semiconductor substrate 12 to a degree to reach the joining surface S of the semiconductor substrate 12 and the transparent substrate 11 (refer to Fig. 2).

Furthermore, dicing may be performed to the depth exceeding the joining surface S to the transparent substrate 11, as long as the dicing blade 21 for semiconductor substrates is not broken.

The first dicing blade 21 is a blade for semiconductor substrates as described above, and the blade having a width and made of a material most suited to the dicing of semiconductor substrates is used.

Specifically, as the first dicing blade 21, for example, a narrow dicing blade wherein the width is designed to be narrower than the second dicing blade 22 (refer to Fig. 3) used in the second dicing step described below is used.

In the next step, the second dicing is performed to the hetero-junction substrate 10 after the above-described first dicing step. In the second dicing step, dicing is performed to a region W2 between two grooves 12a and 12b formed in the first dicing step on the outer surface of the semiconductor substrate 12 (refer to Fig. 3), using a second dicing blade 22 for transparent substrates wider than the above-described first dicing blade 21. The second dicing step is a step of dicing from the back-face side of the semiconductor substrate 12 to the transparent substrate 11, i.e. the entire hetero₋junction substrate 10 to singulate the substrate into a plurality of semiconductor chips.

The second dicing blade 22 is a blade for transparent substrates as described above, and the blade having a width and made of a material most suited to the dicing of transparent substrates is used.

Here, although the second dicing step using the second dicing blade 22 is described to be performed from the back-face side of the semiconductor substrate 12, the present invention is not limited thereto, but for example, the second dicing step may be performed from the surface side of the transparent substrate 11.

In respective semiconductor chips 16 singulated in the second dicing step, notches 12c are formed in the peripheral portions in the back-face side of the semiconductor substrate 12, as shown in Fig. 4. The formation of the notches 12c has an effect to avoid the generation of chippings.

Each of the plurality of semiconductor chips 16 singulated in this way is fabricated as a solid-state image pickup apparatuses (semiconductor devices) 1 packaged in a chip size.

As described above, according to the first embodiment, in the method for fabricating a semiconductor device 1 having a hetero-junction substrate 10 of a form wherein a semiconductor substrate 12 is joined to a transparent substrate 11, which is a heterogeneous substrate different from the semiconductor substrate 12, the hetero-junction substrate 10 is singulated into a plurality of semiconductor chips 16 by the two-stage dicing process using dicing blades (21, 22) of forms most suited to the semiconductor substrate 12 and the transparent substrate 11, respectively; specifically, by the first dicing step of first dicing only the side of the semiconductor substrate 12, and then, the second dicing step for the entire hetero₋junction substrate.

Thereby, the quantity of chippings occurring from both the semiconductor substrate 12 and the transparent substrate 11 in the dicing process can be reduced, or the semiconductor chips 16 can be singulated while avoiding the occurrence of chippings.

The present embodiment can contribute to the improvement of yield in the fabrication of a solid-state image pickup apparatus (semiconductor device) 1 composed using the semiconductor chips, and at the same time, a highly reliable semiconductor device can be fabricated.

The present invention is highly effective for small implementation, such as CSP (chip size package).

Next, a method for fabricating a semiconductor device according to a second embodiment of the present invention will be described hereunder.

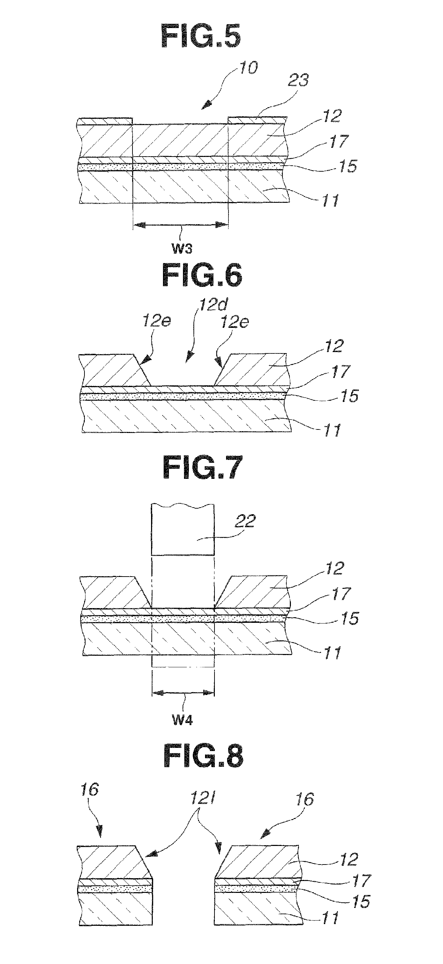

Figs. 5 to 8 are diagrams for illustrating a method for fabricating a semiconductor device according to the second embodiment of the present invention. Of these diagrams, Figs. 5 and 6 are sectional views showing a first dicing (etching) step. Fig. 5 shows a state wherein an etching mask is disposed on the back side of a semiconductor substrate. Fig. 6 shows a state after the completion of the first dicing (etching) step. Fig. 7 is a sectional view showing a second dicing step. Fig. 8 is a sectional view showing a part of a semiconductor chip (only a vicinity of a diced region) in a semiconductor device singulated in two-stage dicing steps.

Also in the method for fabricating a semiconductor device according to the present embodiment, the dicing process is performed in two stages in the same manner as in the above-described first embodiment. However, in the present embodiment, the first dicing step is performed by a chemical processing, such as an etching treatment; and the second dicing step is performed by a mechanical processing.

Specifically, for example in the first dicing step, the dicing region of the semiconductor substrate 12 is removed by a chemical processing as shown in Figs. 5 and 6; and then in the second dicing step, the transparent substrate 11 is diced by a mechanical processing using a dicing blade to singulate into a plurality of semiconductor chips 16 as shown in Figs. 7 and 8.

The fabricating method of a semiconductor device according to the present embodiment will be described in further detail.

In the process in the method for fabricating a semiconductor device, prior to the dicing process, first, a hetero-junction substrate 10 to be diced, specifically, a hetero-junction substrate 10 of a form wherein a transparent substrate 11 is joined on the surface of a semiconductor wafer (semiconductor substrate 12) is formed in the same manner as in the above-described first embodiment.

In the present embodiment, two-stage dicing by a chemical processing and a mechanical processing is performed to singulate the hetero-junction substrate 10 into a plurality of semiconductor chips.

First, in the first dicing step, as shown in Fig. 5, the portion of the hetero-junction substrate 10 excluding a predetermined dicing region W3 (refer to Fig. 5) in a semiconductor substrate 12, such as a silicon substrate, is coated with an etching mask 23. In this state, the dicing region W3 of the semiconductor substrate 12 is etched from the back-face side. Thereby, a trapezoidal groove 12d is formed in the dicing region W3 in the back-face side of the outer surface of the semiconductor substrate 12 as shown in Fig. 6.

The etching treatment may be wet etching using an etchant, such as a TMAH solution and a KOH solution; or may be dry etching.

Although either anisotropic etching or isotropic etching may be used, in the present embodiment, anisotropic etching is more preferable when the etched shape is considered.

The cross-sectional shape of the portion after the above-described anisotropic wet etching treatment using a TMAH solution or a KOH solution has been performed is a tapered cross-sectional shape as shown in Fig. 6. By anisotropic dry etching treatment, the cross-sectional shape becomes substantially vertical.

On the surface of the semiconductor substrate 12 on the side to become the surface for bonding to the transparent substrate 11, an etching stop layer 17 is formed. By the etching stop layer 17, etching is stopped. As the etching stop layer 17, for example, an oxide film, a metal film, or the like is used.

However, although the formation of an etching stop layer is not particularly required in the case of a hetero-junction substrate formed by bonding a semiconductor substrate 12 to a heterogeneous substrate that is not etched, when an adhesive such as a resin is intervened for bonding the substrates to each other, it is preferable to form the etching stop layer.

In the following step, second dicing is performed to the hetero-junction substrate 10 after the above-described first dicing step. In the second dicing step, dicing is performed to the region W4 (refer to Fig. 7) of the base portion of the groove 12d having a trapezoidal cross section formed on the outer surface of the semiconductor substrate 12 using a second dicing blade 22 for transparent substrates as shown in Fig. 7. Thereby, the hetero₋junction substrate 10 is singulated into a plurality of semiconductor chips as shown in Fig.8.

As the second dicing blade 22, a dicing blade having a width and made of a material most suited to the dicing of transparent substrates 11 is used, similarly to the dicing blade used in the second dicing step of the first embodiment described above.

Respective semiconductor chips 16 singulated in the second dicing step have end surfaces 12e formed on the peripheral sides of the semiconductor substrate 12 as shown in Fig. 8.

As described above, according to the second embodiment, the effect substantially the same as the effect of the first embodiment can be obtained.

In the present embodiment, the first dicing step is performed by etching, which is a chemical processing and the second dicing step is performed by dicing using a dicing blade, which is a mechanical processing.

Thereby in the first dicing step, within the range of the predetermined dicing region W3 (the region other than the portion coated with the etching mask 23), the semiconductor (silicon) is removed by etching. Therefore, no chipping occurs on the end surfaces 12e of the semiconductor substrate 12 when second dicing is performed in the second dicing step.

Also in the present embodiment, since dicing by a mechanical processing is performed only once, the process is simplified. At the same time, contamination or the like caused by dicing by a mechanical processing can be reduced. For this reason, the present embodiment can contribute to the further improvement of yield, and can fabricate a semiconductor device of higher reliability.

The present invention is highly effective for small implementation, such as CSP (chip size package) in the same way as in the first embodiment.

In addition, since the etching stop layer 17 is formed in the joint site between the semiconductor substrate 12 and the transparent substrate 11, the trouble wherein the adhesive 15 or the like used for bonding is exposed to and dissolved in the etchant or the like can be prevented.

Next, a method for fabricating a semiconductor device according to a third embodiment of the present invention will be described hereunder.

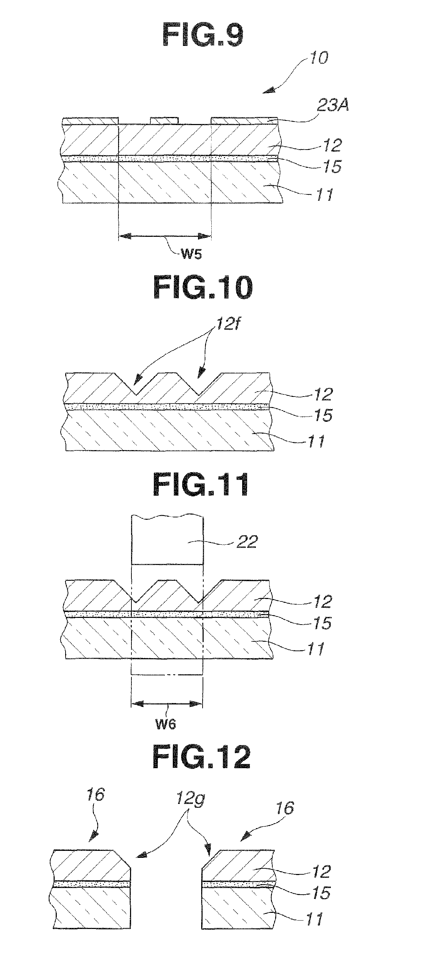

Figs. 9 to 12 are diagrams for illustrating a method for fabricating a semiconductor device according to the third embodiment of the present invention. Of these diagrams, Figs. 9 and 10 are sectional views showing a first dicing (etching) step. Fig. 9 shows a state wherein an etching mask is disposed on the back side of a semiconductor substrate. Fig. 10 shows a state after the completion of the first dicing (etching) step. Fig. 11 is a sectional view showing a second dicing step. Fig. 12 is a sectional view showing a part of a semiconductor chip (only a vicinity of a diced region) in a semiconductor device singulated in two-stage dicing steps.

Also in the method for fabricating a semiconductor device according to the present embodiment, the dicing process is performed in two stages in the same manner as in the above-described first and second embodiments. In the present embodiment, in the same way as in the second embodiment, the first dicing step is performed by a chemical processing, such as an etching treatment; and the second dicing step is performed by a mechanical processing. In this case, in the present embodiment, the form of the etching mask in the first dicing step is different.

Specifically, for example, in the first dicing step, two V-shaped grooves 12f (refer to Fig. 10) are formed by a chemical processing (wet etching or dry etching) of the both end portions of the dicing region in the semiconductor substrate 12 as shown in Figs. 9 and 10. In the second dicing step, by dicing both the semiconductor substrate 12 and the transparent substrate 11 by a mechanical processing using a second dicing blade 22 having a large width, the substrates are singulated into a plurality of semiconductor chips 16 as shown in Figs. 11 and 12.

The fabricating method of a semiconductor device according to the present embodiment will be described in further detail.

In the fabricating method of a semiconductor device, the formation of a hetero-junction substrate 10 to be diced prior to the dicing process, specifically, the formation of a hetero-junction substrate 10 of a form wherein a transparent substrate 11 is joined on the surface of a semiconductor wafer is the same as in the first and second embodiments. In the present embodiment, the hetero-junction substrate 10 is formed without forming the etching stop layer.

In the present embodiment, two-stage dicing by a chemical processing and a mechanical processing is performed to singulate the hetero-junction substrate 10 into a plurality of semiconductor chips.

First, in the first dicing step, as shown in Fig. 9, the portion of the hetero-junction substrate 10 excluding a predetermined dicing region W5 (refer to Fig. 9) in a semiconductor substrate 12, such as a silicon substrate, is coated with an etching mask 23A. In this state, the dicing region W5 of the semiconductor substrate 12 is etched from the back-face side.

Thereby, two V-shaped grooves 12f with V-shaped cross-sectional shape are formed in the dicing region W5 in the back-face side of the outer surface of the semiconductor substrate 12 as shown in Fig. 10. The depth of the V-shaped grooves 12f is designed so as not to reach from the back-face side of the semiconductor substrate 12 to the joining surface with the transparent substrate 11.

In this case, the depth of the V-shaped grooves 12f formed by etching treatment may be designed to be within a range not to reach the transparent substrate 11, and it is preferable that the depth is to the site immediately before reaching the transparent substrate 11.

The etching treatment itself is substantially the same as the etching treatment in the first dicing step of the second embodiment.

The cross-sectional shape of the etched portion after the above-described anisotropic wet etching treatment using a TMAH solution or a KOH solution has been performed is a tapered shape (V-shape) as shown in Fig. 10. By anisotropic dry etching treatment, the cross-sectional shape becomes substantially vertical.

In the following step, second dicing is performed to the hetero-junction substrate 10 after the above-described first dicing step. In the second dicing step, dicing is performed using a second dicing blade 22 for transparent substrates having a width across the two V-shaped grooves 12f formed on the outer surface of the semiconductor substrate 12 in the above-described first embodiment, for example, the width of the second dicing blade 22 being the region W6 (refer to Fig. 11) as shown in Fig. 11. Thereby, the hetero-junction substrate 10 is singulated into a plurality of semiconductor chips as shown in Fig.12.

As the second dicing blade 22, a dicing blade having a width and made of a material most suited to the dicing of transparent substrate 11 is used, similarly to the dicing blade used in the second dicing step of the first and second embodiments described above.

Respective semiconductor chips 16 singulated in the second dicing step have chamfer portions 12g formed on the peripheral portions of the back-face sides of the semiconductor substrate 12 as shown in Fig. 11.

As described above, according to the third embodiment, the effect substantially the same as the effect of the first and second embodiments can be obtained.

In the present embodiment, in the same way as in the second embodiment, the first dicing step is performed by a chemical processing (etching), and the second dicing step is performed by a mechanical processing (dicing using a dicing blade). In this case, two V-shaped grooves 12f are formed by using different etching masks 23A in the first dicing step.

When etching treatment is performed, since the depth of the two V-shaped grooves 12f is designed not to reach the joining surface between the semiconductor substrate 12 and the transparent substrate 11, the trouble wherein the adhesive or the like used to bond the substrates 11 and 12 is exposed to and dissolved in the etchant or the like can be prevented without an etching stop layer. By the third embodiment, the effect equivalent to the effect of the second embodiment can be obtained.

In the above-described embodiments, a hetero-junction substrate formed by joining the semiconductor substrate 12, such as silicon substrate, and the transparent substrate 11, such as a glass substrate is used as the hetero-junction substrate 10. In this case, as the means to bond the substrates 11 and 12, for example, adhesives, thermal welding, anodic bonding or the like are used.

As the semiconductor substrate 12, in addition to the above-described silicon substrate, a compound semiconductor substrate, such as a GaAs substrate may also be used.

As the substrate bonded to the semiconductor substrate 12, in addition to the above-described glass substrate, for example, a transparent substrate formed of quartz or plastics may be used, or a ceramic substrate or a glass-epoxy substrate may also be used.

For the optical sensor device, such as a solid-state image pickup apparatus, although the use of a transparent substrate is most suited for the necessity of radiating light to the light receiving section, in the fabrication of general semiconductor devices other than a solid-state image pickup apparatus, the use of a transparent substrate is not necessarily required as a matter of course.

The present invention is not limited to the above-described embodiments, but various modifications or applications can of course be made without departing from the scope of the invention. Furthermore, inventions in various stages are included in the above-described embodiments, and various inventions can be extracted depending on appropriate combinations in a plurality of disclosed constituent requirements. For example, even if some constituent requirements are removed from all the constituent requirements exhibited in the above-described embodiments, when the problems described in the column of "Problems to Be Solved" can be solved, and the effect described in "Effect of the Invention" can be obtained, the configuration from which the constituent requirements are removed can be extracted as an invention.

The present application is filed on the basis of the claim of property for Japanese Patent Application No. 2005-363696 filed on 16 December 2005. The contents disclosed by the above-described basic application are cited in the Description, Claims, and Drawings.

## Claims

1. A method for fabricating a semiconductor device composed including a hetero-junction substrate formed of a semiconductor substrate and a heterogeneous substrate made of a material other than semiconductor bonded to a surface of the semiconductor substrate, wherein
a dicing step of cutting the hetero-junction substrate into semiconductor chips comprising:
a first dicing step of forming grooves having a depth of at least half the thickness of the semiconductor substrate on the surface of the semiconductor substrate; and
a second dicing step of cutting the entire hetero-junction substrate along the grooves so as to divide the hetero-junction substrate into a plurality of semiconductor chips.

2. The method for fabricating a semiconductor device according to claim 1, wherein the first dicing step and the second dicing step are performed by a mechanical processing.

3. The method for fabricating a semiconductor device according to claim 2, wherein each of the first dicing step and the second dicing step uses a dicing blade having a different width and composed of a different material from each other.

4. The method for fabricating a semiconductor device according to claim 1, wherein the first dicing step is performed by a chemical processing and the second dicing step is performed by a mechanical processing.

5. The method for fabricating a semiconductor device according to claim 4, wherein the first dicing step is performed by either one of wet etching and dry etching.

6. The method for fabricating a semiconductor device according to any one of claims 1 to 5, wherein the semiconductor device is composed of a hetero- junction substrate formed of a semiconductor substrate on which a plurality of solid-state image pickup apparatuses are formed, and a transparent substrate.

7. The method for fabricating a semiconductor device according to any one of claims 1 to 6, wherein the semiconductor device is a CSP-type semiconductor device.
